# EUROPEAN PATENT APPLICATION

(11) **EP 2 587 494 A2**
(43) Date of publication of application: **01.05.2013**
(21) Application number: 12189733.4
(22) Date of filing: 24.10.2012
(51) Int. Cl.: H01F 6/06, H01L 39/24

(54) **Superconducting magnet and method of producing same**

(30) Priority: 25.10.2011 JP 2011233699
(71) Applicant: Hitachi Ltd., Tokyo 100-8280 (JP)
(72) Inventor: Ichiki, Yota, Tokyo, 100-8220 (JP); Tanaka, Kazuhide, Tokyo, 100-8220 (JP)
(74) Representative: MERH-IP Matias Erny Reichl Hoffmann

(57) **Abstract**

A superconducting magnet (10) includes a superconducting wire (1)including magnesium diboride; a superconducting coil (2) where a part (2b) of the superconducting wire is wound; and a joint (3) where an end (1a, 1b) of the superconducting wire and an end of another superconducting wire (1c) are connected and united. The joint includes a sintered body (3c) including magnesium diboride, an averaged particle diameter (D2) of magnesium diboride at the joint of the superconducting wire is greater than an averaged particle diameter (D1) of the magnesium diboride at the part where the superconducting wire is wound.

## Description

### BACKGROUND OF THE INVENTION

### 1. Field of the Invention

The present invention relates to a superconducting magnet and a method of producing the same.

### 2. Description of the Related Art

Magnesium diboride (MgB₂) has a critical temperature (transition temperature) of 39 K. This temperature is higher than critical temperatures of the conventional metal super conductors (for example, niobium titanium (NbTi), the niobium 3-tin (Nb₃Sn), etc.). Unlike a wire using an oxide superconductor, a wire using the magnesium diboride has an advantageous effect in that a magnetic field stability when a closed circuit with the wire using the magnesium diboride is operated in the persistent current mode is high.

The persistent current mode is a mode in which an operation method of continuing to allow the current to flow in the closed circuit formed using a superconductor. More specifically, because the superconducting wire has a resistance of zero, once a current flows in a closed circuit, the current continues flowing in the closed circuit. To provide such a persistence current mode, generally, a technology for connecting ends of the superconducting wires with a superconductor becomes important.

For example, the following technologies are known to connect the magnesium diboride wires each other, and the magnesium diboride wire to another wire such as a niobium titanium wire, a niobium 3-tin wire, etc.

For example, JP2006-174546 A discloses a method of connecting a magnesium diboride wires using a superconducting solder. The method of connecting the superconducting wire using a superconducting solder is used in a method of connecting another superconducting wires such as niobium titanium wires, etc.

In addition, for example, JP 2003-22719 A discloses a method of connecting magnesium diboride wires including inserting the niobium titanium wires into a pipe, then, filling the pipe with a magnesium diboride powder, and pressure-bonding them. In addition, to enhance a connectivity between particles of the magnesium diboride powder, a method of mixing a metal having a lower melting point is also disclosed.

For example, "A Superconducting Joint Technique for MgB2 Round Wires" of a Non-patent document discloses that wires containing a mixture powder of magnesium and boron or magnesium diboride wires are inserted into a sleeve container which is filled with the mixture powder from a side opposite to the wires and pressurized, and is subjected to a heat treatment. As a result of the heat treatment, magnesium diboride is produced and Non -patent document below discloses the method of connecting the magnesium diboride wires.

### [Non-patent document]

W. Yao et al. "A Superconducting Joint Technique for MgB2 Round Wires", IEEE Transaction on Applied Superconductivity, Vol. 19, No. 3, (2009).

In the technology described in JP2006-174546 A, because the superconducting solder has a critical temperature lower than about 9 K, an operating temperature cannot be set to 10 K or more. More specifically, even if a superconducting magnet using magnesium diboride having a relatively high critical temperature (39 K) is used, the magnet should be cooled at or lower than 10 K, so that the characteristic of the superconducting wire is not sufficiently utilized.

In the technology disclosed in JP 2003-22719 A, a connectivity between particles of magnesium diboride is poor because powder of magnesium diboride is charged and crimped. This configuration cannot provide a sufficient conductivity characteristics required for the superconducting magnet. In addition, to increase the connectivity between particles, an additional process such as mixing a low melting metal becomes necessary.

In the technology described in "A Superconducting Joint Technique for MgB2 Round Wires" of the non-patent document, a magnesium diboride wire may be heated again in a heat treatment for reacting magnesium with boron at a joint. As a result, a conductivity characteristic of a magnesium diboride wire may decrease.

### SUMMARY OF THE INVENTION

An aspect of the present invention provides a superconducting magnet including a superconducting wire connectable with decrease in a conductive characteristic being suppressed.

An aspect of the present invention provides a superconducting magnet including a magnesium diboride wire (superconducting wire) undergone a predetermined heat treatment process to be connectable with decrease in the conductive characteristic being suppressed.

An aspect of the present invention provides a superconducting magnet comprising:
a superconducting wire including magnesium diboride;
a superconducting coil, wherein a part of the superconducting wire is wound; and
a joint where an end of the superconducting wire and an end of another superconducting wire are connected and united; wherein the joint includes a sintered body including magnesium diboride, an averaged particle diameter of magnesium diboride at the joint of the superconducting wire is greater than an averaged particle diameter of the magnesium diboride at the part of the superconducting wire.

An aspect of the present invention provides a method of producing the superconducting magnet as described above, comprising:
a coil producing process comprising:
   winding a wire comprising a material including magnesium and diboride; and
   a first heat treatment process applying a heat treatment to the part of the wire at a first temperature and the end of the wire at a second temperature higher than the first temperature; and
   a second heat treatment process forming the joint to unify an end of the wire with another superconducting wire.

### BRIEF DESCRIPTION OF THE DRAWINGS

The object and features of the present invention will become more readily apparent from the following detailed description taken in conjunction with the accompanying drawings in which:
Fig. 1 is a cross section view, a whole structure according to embodiment of the present invention of a superconducting magnet;
Fig. 2 is a perspective view schematically shown the whole of the superconducting coil and ends thereof according to the embodiment of the present invention;
Fig. 3 is perspective view, partially schematic view, of the superconducting magnet according to the embodiments of the present invention under forming the joint;
Fig. 4 is a chart illustrating a relationship between a magnetic field and a critical current in the superconducting wire according to an example of the embodiment of the present invention;
Fig. 5 is a chart illustrating a relationship between a magnetic field and a critical current in comparative examples of the superconducting wires according to embodiment of the present invention ;
Fig. 6 shows a relation in particle diameter between the particles at the ends and the winding part of the wire according to the embodiment of the present invention; and
Fig. 7 shows a winding process in the coil producing process according to the embodiment of the present invention.

The same or corresponding elements or parts are designated with like references throughout the drawings.

### DETAILED DESCRIPTION OF THE INVENTION

With reference to drawings will be described embodiments of the present invention. However, the present invention is not limited by the content below, but may be embodied with any modification without departure from the subject matter of the present invention.

### [1. Structure of Superconducting Magnet According to Embodiment]

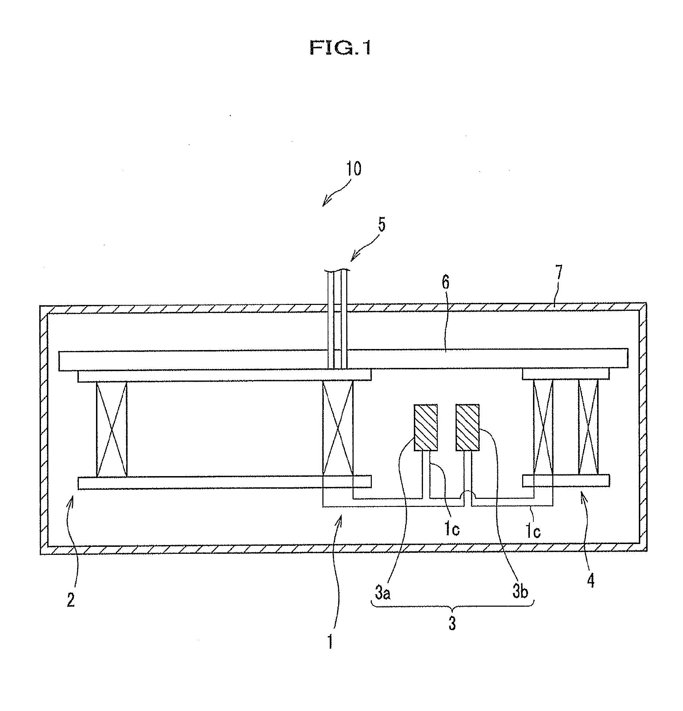

First, referring to Fig. 1, will be described a whole structure of the superconducting magnet according to the embodiment. As shown in Fig. 1, the superconducting magnet 1 includes a superconducting coil 2 in which the superconducting wire 1 is wound, a joint 3, a persistent current switch 4, a current lead 5, a supporting plate 6, and a frame (cryostat) 7.

The superconducting wire 1 is a wire containing magnesium diboride. Niobium magnesium, having a critical temperature of 39K, can facilitate to operate a superconducting magnet at an operating temperature (10-20 K) higher than the conventional operating temperature provided by cooling to 4.2 K with liquid helium.

A shape of the superconducting wire 1 is not specifically limited and generally a wire in which magnesium boride is covered with a metal part. More specifically, a metal sheath is filled with magnesium diboride. The superconducting wire 1 is not specifically limited in cross section shape, but a circular shape is used in this embodiment. The superconducting wire 1 has a circular cross section shape, which provides an advantageous effect that the wire can be easily wound on a bobbin when manufacturing the superconducting coil 2 (described later).

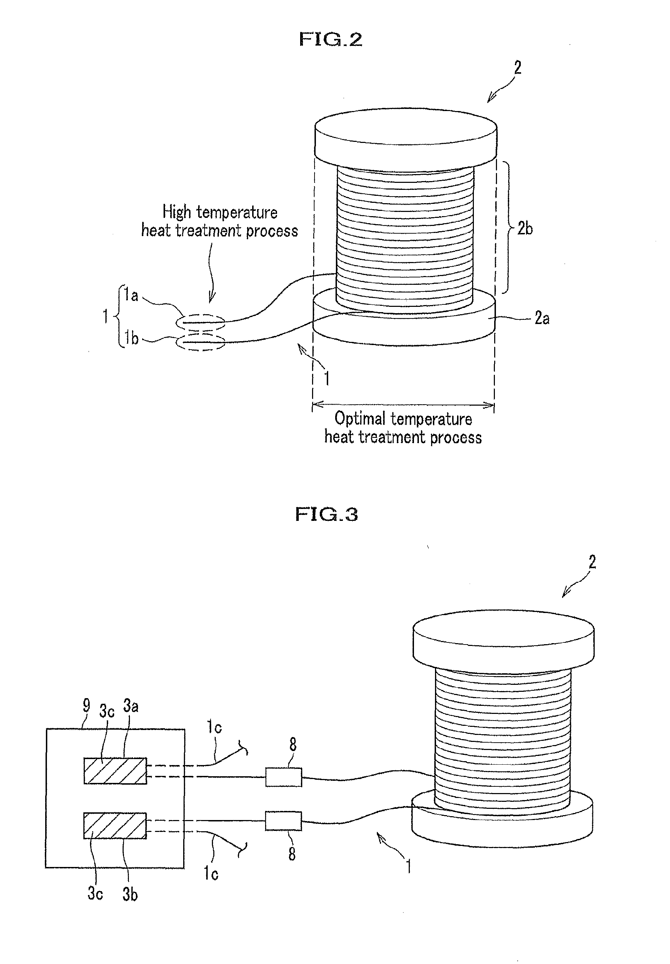

The superconducting coil 2 is formed by winding the superconducting wire 1 around the bobbin 2a (core: see Fig. 2). Both ends of the superconducting wire 1 wound in the superconducting coil 2 are connected to the persistent current switch 4 through the joint 3 (3a, 3b). Detail descriptions of the joint 3 and the persistent current switch 4 will be made later.

In addition, connected to the superconducting coil 2 is a current lead 5 for supplying a current to the superconducting coil 2 when the persistent current switch 4 is OFF. Accordingly, when the persistent current switch 4 is OFF, it is configured that a current flows through the superconducting wire 1 wound as the superconducting coil 2 through the current lead 5 from an external power supply (not shown). More specifically, the superconducting coil 2 is configured to be excited when the persistent current switch 4 is OFF.

The number of the superconducting coils 2 is one in Fig 1. However, a plurality of the superconducting coils 2 are provided in accordance with the necessity. When a plurality of the superconducting coils 2 are provided, the number of the joints 3 are increased because the superconducting coils 2 are connected each other in series.

The joint 3 is a part for connecting an end of the superconducting wire 1 forming the persistent current switch 4 to an end of the superconducting wire 1 wound in the superconducting coil 2 as the ends unified. The joint 3 is a sintered body 3c containing magnesium diboride.

The persistent current switch 4 is generally provided by winging the superconducting wire 1 around a bobbin without inductance. When the persistent current switch 4 is heated as described earlier, the persistent current switch 4 turned OFF because phase transient occurs, i.e., the conducting state shifts from the superconducting state to the normal state. As a result, a current becomes flowing into the superconducting wire 1 from the external power supply through the current lead 5.

On the other hand, when heating the persistent current switch 4 is stopped, the persistent current switch 4 is cooled with a refrigerator (not shown), or a coolant (liquid helium), so that a phase transient occurs to the superconducting state, i.e., the switch is turned on. Accordingly, a closed circuit is formed between the superconducting coil 2 and the persistent current switch 4. As a result, the current that has been supplied from the external power supply continues to flow through the closed circuit as a persistent current, which keeps a high stable magnetic field.

The current lead 5 is connected to the external power supply as described above. When the persistent current switch 4 is turned OFF, the current from the current lead 5 flows through the superconducting coil 2. In addition, when the persistent current switch 4 is turned ON and thus the current from the external power supply becomes zero, the current flowing in the closed circuit continues to flow.

The supporting plate 6 and the frame (cryostat) 7 are provided to fix the superconducting coil 2 and the persistent current switch 4 to keep the cryogenic temperature. Accordingly, as long as the members to form the superconducting magnet 10 are surely fixed and thermally insulated from the external, a concrete structure and kind are not limited, but may be used arbitrary.

Next, with reference to Fig. 2, will be described the ends 1a, 1b of the superconducting wire 1 wound around the superconducting coil 2. As described above, and as shown in Fig. 2, the superconducting coil 2 is provided by winding the superconducting wire 1 around the bobbin 2a. The ends 1a, 1b of the superconducting wire 1 are connected to the external (more specifically, the persistent current switch 4 shown in Fig. 2) through the joint 3. In other words, the superconducting wire 1 is connected to another superconducting wire at the ends 1a, 1b.

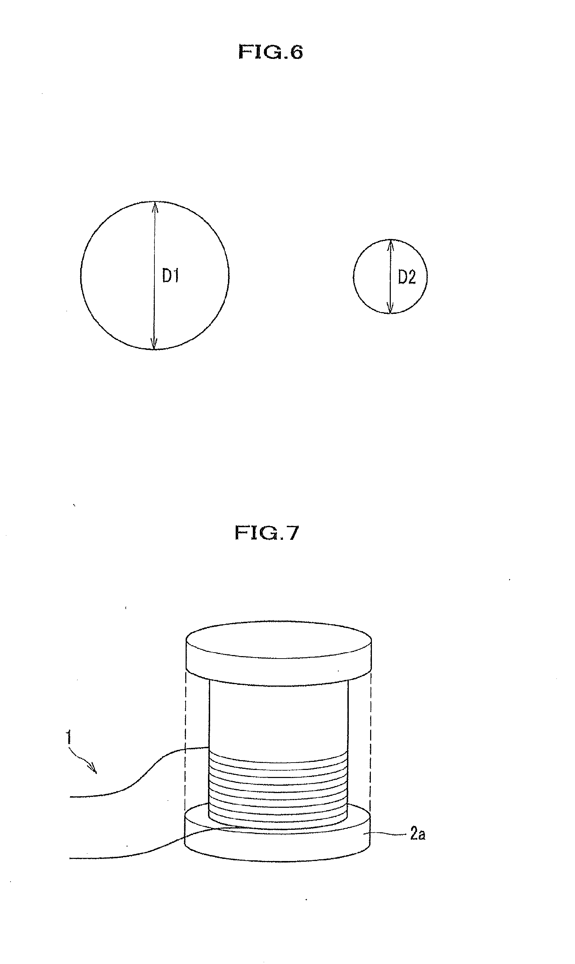

As described above, the superconducting wire 1 contains magnesium diboride. Fig. 6 shows a relation in particle diameter between the particles at the ends 1a, 1b and a winding part 2b. An averaged particle diameter D1 of magnesium diboride at the ends 1a, 1b of the superconducting wire 1 in the superconducting coil 2 is greater than an averaged particle diameter D2 at the part where the wire is wound (winding part 2b: see Fig. 2). The configuration is made as described above, and suppresses a decrease in a conductivity characteristic with a preferable connection of the superconducting wire with another superconducting wire material.

Here, will be described a definition of "averaged particle diameter" in the present invention. The "averaged particle diameter" in the present invention, is an average value of particle diameters measured by that a plurality of particles of magnesium diboride are shot (observed) with an electron scanning microscope (SEM) and the average value of particle diameter is obtained by measuring particle diameters of one hundred of the particles out of the shot particles.

Strictly, the particle in the SEM photograph does not have a circular shape. Accordingly, an averaged diameter value of one particle is obtained by averaging the longest diameter and the shortest diameter of the particle. In addition, because there are extremely large numbers of particles in a cross section of the superconducting wire 1, the average particle diameter is assumed to be approximately the same even if the superconducting wire 1 is cut at any position in the longitudinal direction.

Accordingly, "the averaged particle diameter D1of magnesium diboride at the ends 1a, 1b" can be measured below. More specifically, at first, the ends 1a, 1b of the superconducting wire 1 are cut in a direction perpendicular to a current carrying direction and polished. The superconducting wire 1 used in this process is one after the first heat treatment (described later).

After that, a state of magnesium diboride is observed with the SEM on the polished cross section. A magnification for this can be arbitrary set to such an extent that magnesium diboride can be sufficiently observed. The averaged particle diameter can be measured by the method described above from the observed magnesium diboride. Similarly "an averaged particle diameter D2 at the winding part 2b" can be obtained.

As described above, the averaged particle diameter D1 of magnesium diboride at the ends 1a, 1b of the superconducting wire 1 is grater than the averaged particle diameter D2 of magnesium diboride at the part of the bobbin 2a where the superconducting wire 1 is wound (winding part 2b). Setting the average particle diameters like this can suppress deterioration in a current carrying characteristic of the superconducting wire 1 during the heat treatment for connecting the superconducting wire 1 to another superconducting wire at the ends 1a, 1b. In addition, the conductivity characteristic is preferable at the winding part 2b because the averaged particle diameter is small.

There is no limitation in the value of the averaged particle diameters of magnesium diboride at the ends 1a, 1b and the winding part 2b. Though not generally speaking because the particle diameter of magnesium diboride depends on a particle diameter of a boron powder as a raw material, will be described an example using boron powder having an averaged particle diameter of 0.2 µm - 0.3 µm. The averaged particle diameter of magnesium diboride at the ends 1a, 1b is preferably equal to or greater than 0.5 µm, more preferable equal to or greater than 1 µm, and the upper limit is preferably equal to or smaller than 3 µm and more preferably, equal to or smaller than 2 µm. Accordingly, the averaged particle diameter of the magnesium diboride at the winding part 2b is made smaller than the averaged particle diameter in this region.

In addition, the averaged particle diameter at the ends 1a, 1b is more preferably equal to or more than two times, further preferably equal to or more than four times the averaged particle diameter of magnesium boride at the winding part 2b, and the upper limit is preferably equal to or smaller than twenty times and further preferably equal to or smaller than ten times the averaged particle diameter of magnesium boride at the winding part 2b.

Moreover, a length of the part at the boarder between the ends 1a, 1b, which are joints to another superconducting wire and the winding part 2b, in other words, the length of the superconducting wire not wound around the bobbin 2a and not connected to another superconducting wire, is not limited. In addition, the averaged particle diameter of magnesium diboride at such the part is not specifically limited. However, it is preferable that the averaged particle diameter at the ends 1a, 1b is greatest and becomes gradually smaller going in a direction to the winding part 2b. Though detailed descriptions will be omitted, this configuration allows the superconducting coil 2 to be produced in one electric furnace, so that more stable conductivity characteristics are obtained. In addition, the averaged particle diameters at the ends 1a, 1b and the winding part 2b can be controlled easily in one electric furnace at the same time, so that the superconducting coil 2 can be simply manufactured at a low cost.

Moreover when the superconducting wire 1 is connected to another superconducting wire at the ends 1a, 1b, cross sectional shapes of the ends 1a, 1b may be different from the cross section shapes of the superconducting wire 1 wound around the bobbin 2a. More specifically, for example, the cross section shapes of the ends 1a, 1b may be a substantially rectangular and the cross section shapes at the winding part 2b may be a substantially circle. When the cross section shape is set to, for example, the shape like this, it becomes easy to wind the superconducting wire 1 around the bobbin 2a, so that decrease in the conductivity characteristics when the superconducting wire 1 is connected to another superconducting wire can further suppressed.

### [2.Advantageous Effect Provided By Superconducting Magnet According To Present Embodiment]

In the conventional superconducting magnet, a superconductor such as niobium titanium, niobium 3 tin, etc. is generally used. To connect superconducting wires using these superconductors each other, a superconducting solder, represented by lead-bismuth (PbBi) alloy, is used. However, because such superconducting solders have critical temperature equal to or smaller than about 9 K, almost superconducting magnets are operated with cooling at about 4.2 K using liquid helium.

Though having high critical temperatures, oxide superconductors such as bismuth system (Bi₂Sr₂Ca₂Cu₃O₁₀, etc.) are not so suitable for use for superconducting magnets in which high stability in magnetic field is required because the oxide superconductors have electrical resistances slightly higher than the conventional metal system superconductors.

As main advantageous effect, magnesium diboride has a critical temperature higher than niobium titanium, niobium 3-tin, etc., which are conventional superconductors, and a magnetic field stability equivalent to that of the conventional superconductor. Moreover, the oxide superconductor has a critical temperature further higher than the magnesium diboride but has a low magnetic field stability in a persistent current mode because of having a high resistance as described above. Accordingly, when the oxide superconductor is used as the superconducting magnet, it is difficult to apply the oxide superconductor to the superconducting magnet to a magnetic resonance imaging device (MRI; Magnetic Resonance Imaging) and a nuclear magnetic resonance device (NMR; Nuclear Magnetic Resonance) in which high magnetic field stabilities are required.

Therefore, the superconducting magnet according to the embodiment, using magnesium diboride as the superconductor, is particularly suitable for MRI and NMR, etc. in which a high magnetic field stability is required. In other words, when magnesium diboride wire is used as the superconducting wire for the superconducting magnet, the persistent current mode operation can be performed at a high magnetic field stability. In addition, when a preferable conductivity characteristic is kept at 10 K or higher, a superconducting magnet capable of being cooled by a refrigerator without using a liquid helium can be provided.

Moreover, it is possible to connect the superconducting wire to another superconducting wire in accordance with needs in which decrease in a conductivity characteristic is suppressed. More specifically, for example, when a connected component such as the superconducting coil, and the persistent current switch, etc. is broken down, the component can be replaced with a new component while the conductivity characteristic is maintained.

However, as described above, to form a closed circuit capable of being operated at a temperature equal to or higher than 10 K, there may be a case where superconducting wires including magnesium diboride are connected to each other while decrease in the conductivity characteristics is suppressed.

Conventionally, magnesium diboride is produced by the heat treatment applied to a sleeve container into which wires including magnesium and boron, or magnesium diboride wires are inserted and a mixture powder of magnesium and boron is filled and pressurized on a side opposite to the wires (for example, Non-patent document 1). This allows the magnesium diboride wires to be connected each other. In other words, the use of magnesium and boron allows the wires to be connected each other.

On the other hand, when the magnesium diboride wires (i.e., superconducting wires) are connected each other, magnesium diboride in the superconducting wire is heated again. Accordingly, there may be a case where the conductivity characteristics may be decreased in the superconducting wires after being heated again. The inventors consider, through study by the inventors, that this is caused by a difference in a rate of thermal expansion between the metal sheath tube around magnesium diboride and magnesium diboride. It is supposed that the difference is caused by that magnesium diboride in the superconducting wire is mechanically destroyed by a thermal cycle.

To prevent such a phenomenon, the inventors studied and proposed that, for example, a mechanical strength of magnesium diboride in the superconducting wire is enhanced. In other words, the inventor supposed that when the particle diameter of magnesium diboride in the metal tube is small, the particle tends to be destroyed if a force is applied from the external. However, if the particle diameter of magnesium diboride is large, a resistance characteristic to the force from the external will be enhanced because a grater particle diameter increases a binding characteristic between particles.

However, magnesium diboride has a small particle diameter because the greater the grain boundary is, the higher the conductivity characteristics is. Then if the particle diameter is made large to increase a mechanical strength, the conductivity characteristic becomes low.

The present invention is developed in consideration of such the circumstances. In other words, the superconducting magnet according to the embodiment, the averaged particle diameter of magnesium diboride is made large at the ends (joints). More specifically, the averaged diameter is made small at the part where the superconducting wire is wound in the superconducting coil where the best conductivity characteristic is required, but made large at the ends disposed at a location apart from the superconducting coil where the magnetic field is low. This allows the superconducting wires to be connected preferably in which decrease in the current carrying characteristic is suppressed as the whole of the superconducting magnet.

### [3. Method of Producing Superconducting Magnet according to Embodiment]

Next with reference to Figs. 1 to 3 and 7 will be described a method of producing the superconducting magnet according to the embodiment (hereinafter, occasionally referred to as "producing method according to the embodiment"). The producing method for the superconducting coil 2 is mainly described hereinafter, and a detailed description will be omitted because, for example, assembling various kinds of members are arbitrary made.

Generally, the superconducting wire 1 is undergone an extending process after a raw martial powder is filled into the metal sheath tube, that is, manufactured by the so-called "Powder In Tube method (PIT). Particularly, when the raw material powder (magnesium and boron in the case where the superconductor is magnesium diboride) is filled as it is, this method is called "in-situ method". The superconducting wire 1 according to the present invention is a wire produced by this "in-situ method".

In addition, it is preferable to mix the superconducting wire 1 with, for example, silicon carbide, etc to enhance the conductivity characteristics of the wires. In addition, the superconducting wire 1 is generally used as a multi-core wire. However, the production method of the superconducting wire 1 will be described hereinafter as a single core wire having one core for convenience.

The production method according to the embodiment mainly includes respective processes below. Fig. 7 shows a winding process in the coil producing process.
(1) A coil producing process for winding a wire 1 made of at least magnesium and boron around a bobbin 2a as shown in Fig. 7 to produce a coil 2.
(2) A first heat treatment process for producing a superconducting coil in which a part of the wire wound around the bobbin 2a is heat-treated at an optimal temperature (Optimal temperature heat treatment process, see Fig. 2) and the ends 1a, 1b of the wire 1 are heat-treated at a temperature higher than the optimal temperature (High temperature heat treatment process; see Fig. 2).
(3) A second heat treatment process for forming the joint by unifying the end of the superconducting wire undergone the heat-treated at the higher temperature with another superconducting wire (see Fig. 3).

Next respective processes will be described.

### (Coil producing process)

In this process, the metal sheath tube is filled with a material including at least magnesium and boron which is processed into a wire by a wiredrawing process, a rolling process, etc. The produced wire is wound around the bobbin 2a to produce the coils 2, as shown in Fig. 7..

To make the averaged particle diameter of the magnesium diboride at ends of the superconducting wire larger after a first heat treatment process (described later), it can be supposed that the averaged particle diameter of the boron which is a raw material to be charged into the end is enlarged when the raw material is charged into the metal sheath tube. This is because the averaged particle diameter of the magnesium diboride depends on the averaged particle diameter of boron. However, this method is not so realizable because a wiredrawing processability may be lowered and a length of a part of the end of the super conducting wire is determined at a position where boron having a greater averaged particle diameter is charged. Accordingly, it is a more preferable method to control the averaged particle diameter of magnesium diboride by controlling the temperature in the first heat treatment process described later.

### (First heat treatment process)

In this process, the heat treatment process is applied to the coil obtained by winding the wire to produce magnesium diboride by causing a react on magnesium with boron in the metal sheath tube. Generally an electric furnace is used for the heat treatment. Moreover, it is preferable that an atmosphere of the heat treatment is a vacuum, or an inert gas atmosphere such as argon, nitrogen, etc.

As described above, when boron having different particle diameters is filled in the metal sheath tube, the heat treatment at a desired temperature is applied to the whole of the superconducting wire 1 (the whole of the superconducting wire 1 after winding around the bobbin 2a). This can produce the superconducting coil 2. However, from point view of simplicity and reducing the manufacturing cost, it is preferable to control the averaged particle diameters are controlled by controlling a heat treatment temperature. Hereinafter, will be described this method.

When the magnesium diboride is produced from magnesium and boron, there may be a case where a sufficient collecting rate of magnesium diboride is not obtained when the heat treatment temperature is too low because magnesium does not sufficiently react with boron. In addition, when the heat treatment temperature is too high, the particle diameter becomes too large because the crystal growth of magnesium diboride is promoted. Accordingly the conductivity characteristics may be lowered.

However, as described above, to increase a mechanical strength of magnesium diboride at the end of the wire, it is preferable to make the averaged particle diameter of magnesium diboride large. Then, to increase the mechanical strength of the ends 1a, 1b of the superconducting wire, only the ends 1a, 1b are heat-treated at a high temperature.

Accordingly, the heat treatment process is carried out after preparing an electric furnace (not shown) having a temperature gradient provided by adjusting arrangement of electric wire heaters. More specifically, the superconducting coil 2 (before the heat treatment) is placed inside an electric furnace such that the ends 1a, 1b exist just under the heater and the bobbin 2 exists at a place apart from the heater (including the superconducting wire 1 wound). As described above, because the superconducting coil 2 is placed inside the electric furnace, the ends 1a, 1b are undergone the heat treatment at a high temperature ("high temperature heat treatment process" in Fig. 2), the winding part 2b is undergone the heat treatment process at an optimal temperature (lower than the "high temperature")("optimal heat treatment process "in Fig. 2).

When the heat treatment temperature is high, as described above, the crystal growth of magnesium diboride is promoted, so that the average particle diameter becomes large. Accordingly, because two parts of the superconducting coil 2 are undergone the heat treatment process at different temperatures at the same time inside one electric furnace, the heat treatment temperature can be changed by a simpler method. Thus, it is possible to make the averaged particle diameter at the ends 1a, 1b greater than the averaged particle diameter in the winding part 2b. As a result, as described above, the mechanical strength was enhanced at the ends 1a, 1b which decrease in the conductivity characteristics in the superconducting coil 2 is suppressed.

The heat treated temperatures of the ends 1a, 1b, and the winding part 2b are not limited to any values. However, as described above, the average particle diameter of magnesium diboride at the ends 1a, 1b is made greater than that at the winding part 2b. Accordingly, the heat treating temperature for the ends 1a, 1b is generally higher than that for the winding part 2b. More specifically, a temperature difference between the heat treatment temperature for the ends 1a, 1b and the that for the winding part 2b is preferably equal to or higher 50°C and more preferably equal to or higher 100°C, or more preferably equal to or lower than 250°C, or more preferably equal to or lower than 200 °C.

Moreover, the superconducting coil 2 can be produced also by respectively applying the heat treatments to the winding part of the bobbin 2a and the ends 1a, 1b separately, that is, the heat treatment is undergone twice. However, if the heat treatment process is carried out twice for respective parts, a treatment for preventing heat from transmitting should be made for the part not subjected to the heat treatment, so that time and effort become twice for the heat treatment. Accordingly it is preferable to carry out the heat treatment for two different parts of the superconducting wire 1 at different temperatures at the same time.

It is generally sufficient that lengths of the parts of the ends 1a, 1b to be undergone the high temperature heat treatment are equal to or longer than the part of wires to be undergone the heat treatment in the electric furnace in the second heat treatment process described later. However, in consideration of possibility that the joints are cut and connected again due to replacement of components or poor connection, the part undergone the high temperature heat treatment is preferably made longer.

### (Second heat treatment process)

In this process, the joint 3 is formed by unifying the ends 1a and 1b of the superconducting coil 2 obtained in the first heat treatment process with another superconducting wire. Here, another superconducting wire may be, for example, a superconducting wire connected to the persistent current switch, a superconducting wire connected to another coil, and a superconducting wire for wiring. However, even if any superconducting wire is used, it is preferable to apply the high temperature heat treatment to the ends of the wire in the first heat treatment process.

Though a forming method of the joint 3 (connecting method) is not specifically limited, for example, the superconducting wires to be connected are inserted into a container (not shown) and the heat treatment is performed after the mixture powder of magnesium and boron is charged into container. Connecting like this provides end faces of the superconducting wires 1 where magnesium diboride is exposed, are preferably connected without decrease in the conductivity characteristic.

Fig. 3 shows a more specific method of providing the joint 3 (3a, 3b). The part shown by broken lines out of the superconducting wires shown in Fig. 3 is one undergone the high temperature process. Fig. 3, for convenience, shows an enlarge view around the contact parts 3a, 3b, and the electric furnace 9.

In the example shown in Fig. 3, the ends 1a, 1b (not shown in Fig. 3) of the superconducting wire 1, another superconducting wires 1c, magnesium, and boron are inserted or put into a container (not shown) and heated. Heating is carried out in the electric furnace 9 in a vacuum or an inert gas ambient such as argon, nitrogen, etc.

Then this process provides formation of the joint 3. More specifically, at the joint 3, two of the superconducting wires 1 including end faces where magnesium diboride is exposed, are connected (fixed) each other through a sintered body 3c including magnesium diboride. Moreover, the end faces may have a circle shape as they are, or an oval or rectangular shape as a result of process.

By this operation the two superconducting wires 1 are connected by the joint 3 formed with the sintered body 3c including magnesium diboride. Moreover, at least a part of the end faces of the superconducting wire 1 undergone the high temperature process is to be heated in the electric furnace 9.

A cooling part 8 is installed in an intermediate part of the superconducting wire 1 to prevent heat of the electric furnace 9 from being conducted to the superconducting coil 2 or the superconducting wire 1 not to be subjected to the high temperature heat treatment. A configuration of the cooling part 8 is not specifically limited in configuration, but may be carried out by, for example, dipping the part in water.

According to the embodiment, there is provided superconducting magnet including: a superconducting wire including magnesium diboride; a superconducting coil, wherein a part of the superconducting wire is wound; and a joint where an end of the superconducting wire and an end of another superconducting wire are connected and united; wherein the joint includes a sintered body including magnesium diboride, an averaged particle diameter of magnesium diboride at the joint of the superconducting wire is greater than an averaged particle diameter of the magnesium diboride at the part of the superconducting wire.

The averaged particle diameter of the magnesium diboride at the end of the superconducting wire may be inclusively two to twenty times the averaged particle diameter of the magnesium diboride at the part of the superconducting wire.

According to the embodiment there is provided a method of producing the superconducting magnet including: a coil producing process comprising: winding a wire made of a material including magnesium and diboride; and a first heat treatment process applying a heat treatment applied to an end of the wire at a temperature higher than a temperature of a heat treatment applied to the part; and a second heat treatment process forming the joint in which the end of the wire is unified with another superconducting wire.

The temperature of the heat treatment applied to the end in the first heat treatment may be higher than the temperature of the heat treatment in the first heat treatment applied to the part by inclusively 50°C to 250°C.

At least a part of the end of the wire undergone the first heat treatment process may be undergone a heat treatment again in the second heat treatment process.

### [Examples]

The present invention will be described in detail with examples.

According to the producing method described above, the superconducting wire 1 comprising magnesium diboride with a circular shape having a diameter of 0.7 mm in a cross section, is prepared. Then, the superconducting magnet 10 shown in Fig. 1 is produced with the prepared superconducting wire 1.

To sinter the mixture powder of magnesium and boron, it is preferable to carry out the heat treatment process generally at a temperature in a range from 500 to 800°C, more preferably, in a range from 600°C-700°C. From a result of an experiment by the inventors showed that a heat treatment temperature particularly preferable for the superconducting wire 1 having the diameter of 0.7 mm is 630°C. Accordingly, an optimum heat treatment temperature was set to be 630 ° C for the winding part 2b in the first heat treatment process.

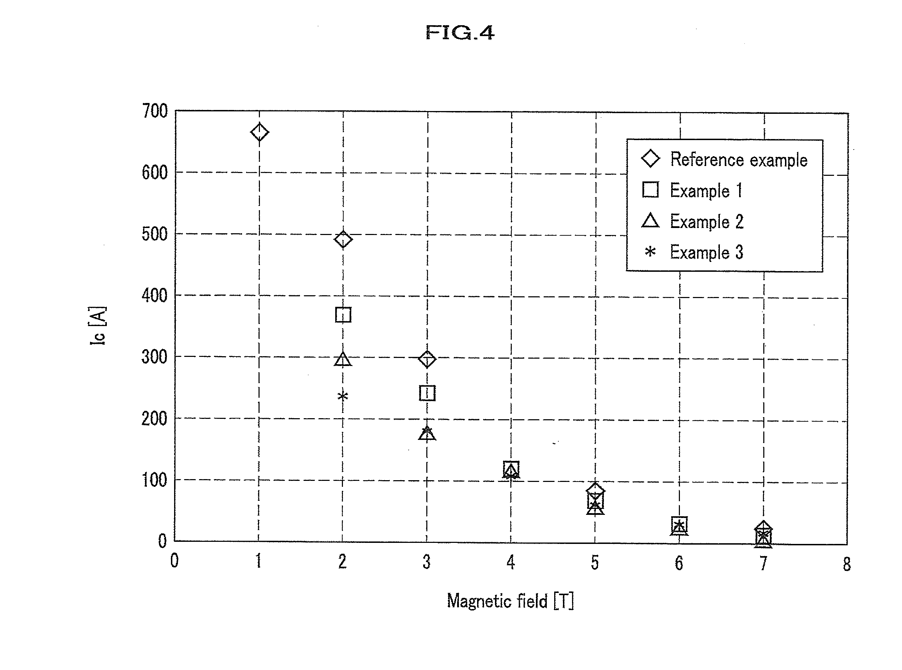

The heat treatment process is carried out for the ends 1a, 1b of the prepared superconducting wire 1 at a temperature (750°C) higher than 630 ° C which is an optimal heat treatment to check decrease in the characteristic in the second heat treatment process. A relationship between the superconducting wire 1 and a critical current (Ic) is shown in Fig. 4.

In Fig. 4, Example 1 shows a case where the heat treatment is carried out once at a temperature of 750° C (i.e., a state before the second heat treatment), Example 2 shows a case where the heat treatment is carried out at a temperature of 750 ° C and a second heat treatment is carried out at 500 ° C, and Example 3 shows a case where the heat treatment is carried out at a temperature of 750°C and the second heat treatment is carried out at 600 ° C. An example where the heat treatment is carried out only once at the temperature of 630°C is also shown as a reference example.

As shown in Fig. 4, though the ends 1a, 1b of the superconducting wire 1 is undergone the heat treatment at the temperature of 750 ° C, there was no large decrease in the conductivity characteristics even though the second process was carried out at a temperature in a range from 500°C-600°C. Accordingly, it was known that the heat treatment for the ends 1a, 1b at a high temperature can make an influence on the conductivity characteristics in the second heat treatment small. A specific averaged particle diameter of the magnesium diboride at the ends 1a, 1b undergone the heat treatment at the temperature of 750 ° C will be described later.

In other words, there was no large influence on the conductivity characteristics though the averaged particle diameter of magnesium diboride is made large by the heat treatment at the high temperature for the ends 1a, 1b. In addition, it becomes known that a mechanical strength of the ends 1a, 1b can be enhanced because the averaged particle diameter of magnesium diboride at the ends 1a, 1b is large.

Regarding the boron used in producing the superconducting wire of Examples 1 to 3 and Reference Example 1, an average particle diameter was set to 0.2 µm to 0.3 µm. In addition, when the heat treatment is carried out with boron having the averaged particle diameter at 630°C which is an optimal heat treatment temperature (see "Reference Example"), the obtained magnesium diboride has an averaged particle diameter of 0.2 µm-0.3 µm. In other words, though the heat treatment is carried out at 630°C, the averaged particle diameters of boron and magnesium diboride are almost unchanged.

The averaged particle diameters are measured by the method described above.

In addition when the heat treatment is carried out at 750°C (see "Example 1" to "Example 3"), the averaged particle diameter of magnesium diboride is 1 µm to 2 µm. Moreover, though this is not shown in the chart, when the heat treatment is carried out at 700°C, the averaged particle diameter is about twice. When the heat treatment is carried out at 700°C, though there was a certain effect by the second heat treatment on suppressing decrease in the conductivity characteristics, there is dispersion in the conductivity characteristic. For example, there was a case where the current does not flow.

In addition, though not shown in the chart, the averaged particle diameter becomes greater by several micron meters when the heat treatment is carried out at 800°C and 900°C, and the conductivity characteristics (critical current) after the first heat treatment becomes about 1/2 and 1/5. However, when the heat treatment is carried out at 800°C and 900°C, though the conductivity characteristics decreases, there is no case where the current stops flowing after the second heat treatment.

From the result above, though depending on an extent of a demand for the current carrying characteristic at the ends 1a, 1b, from a point view of avoiding that the current does not flow, it was known that the temperature of the heat treatment to the ends 1a, 1b in the first heat treatment is preferable to be equal or higher than 750°C and equal to or lower than 800 ° C. More specifically, it became known that the conductivity characteristics can be enhanced by carrying out the heat treatment for the ends 1a, 1b at a temperature (750°C-800°C) higher than the heat treatment temperature (630 ° C) for the winding part 2b and the averaged diameter D1 of magnesium diboride at the ends 1a, 1b is made greater than the averaged particle diameter D2 at the winding part 2b.

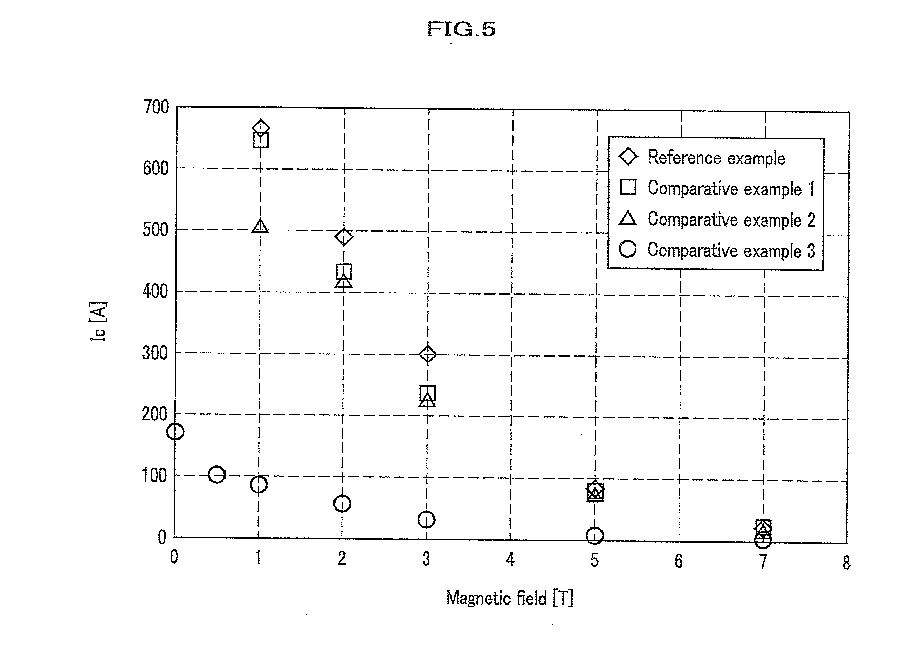

Fig. 5 is a chart illustrating a relationship between a magnetic field and the critical current when the second heat treatment is carried out without the heat treatment for the superconducting wire ends in the first heat treatment process. More specifically, the result shown in Fig. 5 illustrates a chart when the heat treatment temperature is unchanged between the ends 1a, 1b and the winding part 2a, and the averaged particle diameters of magnesium diboride at respective parts are assumed to be substantially the same.

In Fig. 5, in Reference example 1, the heat treatment is carried out at 400°C after the heat treatment at 630 ° C. In Reference example 2, the heat treatment is carried out at 450°C after the heat treatment is carried out at 630°C, and in Reference example 3, the heat treatment is carried out at 500 ° C after the heat treatment at 630°C. Moreover, as a reference example, a curve in which the heat treatment process is not carried out after the heat treatment as 630 ° C is also shown. The reference example is the same as the reference example shown in Fig. 4.

As shown in Fig. 5, there was not so large decrease in the conductivity characteristics when the second heat treatment temperature is equal to or lower than 450°C. However, when the second heat treatment temperature is equal to 500°C, the critical current becomes about 1/10, and when the second heat treatment temperature is equal to 550°C, the critical current becomes zero in a magnetic field of zero. Accordingly, when the second heat treatment is carried out at a temperature equal to or higher than 500°C, it becomes known that the conductivity characteristics largely decreases.

From the result above, when the superconducting wires of which ends are not undergone the high temperature treatment in the first heat treatment process are connected to each other, it becomes known that the conductivity characteristics becomes largely decreased. In other words, it became known that the heat treatment is applied to the ends 1a, 1b at a high temperature in advance to make the averaged particle diameter large, which suppress a decrease in the conductivity characteristics though connection is made with another superconducting wire.

Features, components and specific details of the structures of the above-described embodiments may be exchanged or combined to form further embodiments optimized for the respective application. As far as those modifications are apparent for an expert skilled in the art they shall be disclosed implicitly by the above description without specifying explicitly every possible combination.

## Claims

1. A superconducting magnet comprising:
a superconducting wire (1) including magnesium diboride;
a superconducting coil (2), wherein a part of the superconducting wire (1) is wound; and
a joint (3) where an end of the superconducting wire (1) and an end of another superconducting wire (1c) are connected and united; wherein the joint (3) includes a sintered body (3c) including magnesium diboride, an averaged particle diameter (D2) of magnesium diboride at the joint of the superconducting wire is greater than an averaged particle diameter (D1) of the magnesium diboride at the part of the superconducting wire.

2. The superconducting magnet as claimed in claim 1, wherein the averaged particle diameter (D1) of the magnesium diboride at the end of the superconducting wire (1) is inclusively two to twenty times the averaged particle diameter of the magnesium diboride at the part of the superconducting wire.

3. A method of producing the superconducting magnet as claimed in any one of claims 1 and 2, comprising:
a coil producing process comprising:
winding a wire made of a material including magnesium and diboride; and
a first heat treatment process applying a heat treatment applied to an end of the wire at a temperature higher than a temperature of a heat treatment applied to the part; and
a second heat treatment process forming the joint in which the end of the wire is unified with another superconducting wire.

4. The method of producing the superconducting magnet as claimed in claim 3,
wherein the temperature of the heat treatment applied to the end in the first heat treatment is higher than the temperature of the heat treatment in the first heat treatment applied to the part by inclusively 50°C to 250°C.

5. The method of producing the superconducting magnet as claimed in any one of claims 3 and 4,
wherein at least a part of the end of the wire undergone the first heat treatment process is undergone a heat treatment again in the second heat treatment process.
